# EUROPEAN PATENT SPECIFICATION

(11) **EP 2 660 351 B1**
(45) Date of publication and mention of the grant of the patent: **28.01.2015**
(21) Application number: 13164665.5
(22) Date of filing: 22.04.2013
(51) Int. Cl.: C23C 14/08, C23C 14/34, C23C 14/35, H01J 37/32, H01J 37/34

(54) **Radio frequency tuned substrate biased physical vapor deposition apparatus and method of operation**
Vorrichtung und Verfahren zur PVD-Beschichtung mit radiofrequenzabgestimmter Vorspannung am Substrat
Dispositif et procédé de dépôt en phase vapeur physique aux substrats biaisés et accordés à radiofréquence

(30) Priority: 30.04.2012 US 201213460332
(43) Date of publication of application: 06.11.2013
(73) Proprietor: Fujifilm Corporation, Minato-ku Tokyo 106-8620 (JP)
(72) Inventor: Li, Youming, San Jose, CA 95129 (US); Birkmeyer, Jeffrey, San Jose, CA 95125 (US)
(74) Representative: Hoffmann Eitle

(56) References cited:
- WO-A1-2010/096533
- WO-A1-2010/096533
- US-A- 4 131 533
- US-A1- 2008 236 493
- US-A1- 2010 252 417
- US-A1- 2010 252 417

## Description

### Field of the Invention

The present disclosure relates generally to radio frequency (RF) sputtering physical vapor deposition (PVD).

### Description of the Related Art

Radio frequency sputtering PVD is a method for depositing a thin film on a substrate. The substrate is placed in a vacuum chamber facing a target that is connected to an RF power supply. When the RF power is initiated, a plasma is formed. Positive gas ions are pulled to the target surface, strike the target, and remove target atoms by momentum transfer. The removed target atoms then deposit on the substrate to form a thin film layer. During physical vapor deposition, it can be important to control the properties of the deposited thin film. US Patent No. 2010/0252417 discloses a method of sputtering comprising applying an RF signal to a cathode including a target and connecting a chuck to the ground through an impedance matching network, which comprises an inductor in series with a capacitor.

### SUMMARY OF THE INVENTION

According to the present invention this is achieved by a method as defined in claim 1. Particular embodiments of the invention are defined in claims 2-6. In general, in one aspect, a method of physical vapor deposition includes applying a radio frequency signal to a cathode in a physical vapor deposition apparatus, wherein the cathode includes a sputtering target, electrically connecting a chuck in the physical vapor deposition apparatus to ground through an impedance matching network, wherein the chuck supports a substrate, and wherein the impedance matching network consists of an inductor in series with a capacitor, and depositing material from the sputtering target onto the substrate.

Implementations can include one or more of the following features. A capacitance of the capacitor may be selected or adjusted such that a positive self-bias direct current voltage is generated on the substrate. The positive self-bias direct current voltage may be between 10 and 100V, e.g., between 60 and 75V. Selecting or adjusting the capacitance of the capacitor may include selecting or adjusting the capacitance to have a magnitude of between 10pF and 1200pF. An inductance of the inductor may have a magnitude of between 300µH and 600µH.

The radio frequency signal may have a radio frequency power having a magnitude of between 1 OOOW and 5000W. The target may be a dielectric material, e.g., lead zirconate titanate ("PZT"). Depositing material from the sputtering target onto the substrate may include creating a thin film having a thickness of between 2000Å and 10µm. The thin film may have a thickness of between 2µm and 4µm. Depositing material from the sputtering target onto the substrate may include creating a thin film having a (100) crystalline structure.

In general, in another aspect, a physical vapor deposition apparatus includes a vacuum chamber having side walls, a cathode inside the vacuum chamber, wherein the cathode is configured to include a sputtering target, a radio frequency power supply configured to apply a radio frequency signal to the cathode, an anode inside and electrically connected to the side walls of the vacuum chamber, a chuck inside the vacuum chamber, wherein the chuck is configured to support a substrate, and an impedance matching network electrically connecting the chuck to ground, wherein the impedance matching network consists of an inductor in series with a capacitor.

Implementations can include one or more of the following features. The inductor may be connected between the capacitor and the chuck. The capacitor may be connected between the inductor and ground. The capacitor may have a capacitance between 10pF and 1200pF. The inductor may have an inductance between 300µH and 600µH. The target may be a dielectric material, e.g., lead zirconate titanate ("PZT"). The cathode may include a magnetron assembly. The impedance matching network may have a resonant frequency about 1 to 2 MHz lower than a frequency of the of the radio frequency signal applied to the cathode. The impedance matching network may have a resonant frequency about 1 to 2 MHz higher than a frequency of the of the radio frequency signal applied to the cathode.

A simplified LC circuit can be more stable and easier to tune to provide the desired bias. Since the simplified LC circuit includes fewer components, and there are fewer sources of variation, and consistency in tuning can be improved. In addition, the simplified LC circuit has a single path for current; it should not experience circular currents.

Creating a positive self-bias DC voltage by connecting an impedance network to the chuck can result in the formation of thin films having advantageous piezoelectric and dielectric properties, such as PZT thin films having a dielectric constant in the range of 1000 to 1700, a high d31 coefficient, and a high break-down voltage. Likewise, creating a negative self-bias using an impedance matching network can be advantageous for re sputtering, or etching, of deposited thin films, particularly PZT thin films.

The details of one or more embodiments are set forth in the accompanying drawings and the description below. Other features, aspects, and advantages will become apparent from the description, the drawings, and the claims.

### BRIEF DESCRIPTION OF THE DRAWINGS

FIG. 1 is a schematic of a cross-section of an embodiment of a physical vapor deposition apparatus including an impedance matching network.
FIG. 2A is an enlarged view of the extended anode of FIG. 1.
FIG. 2B shows a perspective view of the extended anode of FIG. 2A.
FIG. 3 is a schematic of a cross-section of an embodiment of a physical vapor deposition apparatus including an impedance matching network and an extended shield.
FIG. 4A is an enlarged view of the extended shield of FIG. 3.
FIG. 4B is a schematic view of the top of an extended shield of FIG. 4A.
FIG. 5 is an example graph of self-bias DC voltage vs. Ar flow for a chuck and a cathode.
FIG. 6 is an example flow chart of a process for depositing a thin film on a substrate using a physical vapor deposition apparatus having an impedance matching network connected to a chuck.

Like reference numbers and designations in the various drawings indicate like elements.

### DESCRIPTION OF THE PREFERRED EMBODIMENTS

When RF physical vapor deposition, or sputtering, is used to create a thin film on a substrate, it can be difficult to control the properties of the deposited film. By altering the DC self-bias of the substrate, for example by connecting the chuck to ground through an impedance matching network to the chuck, the properties of the film can be better controlled.

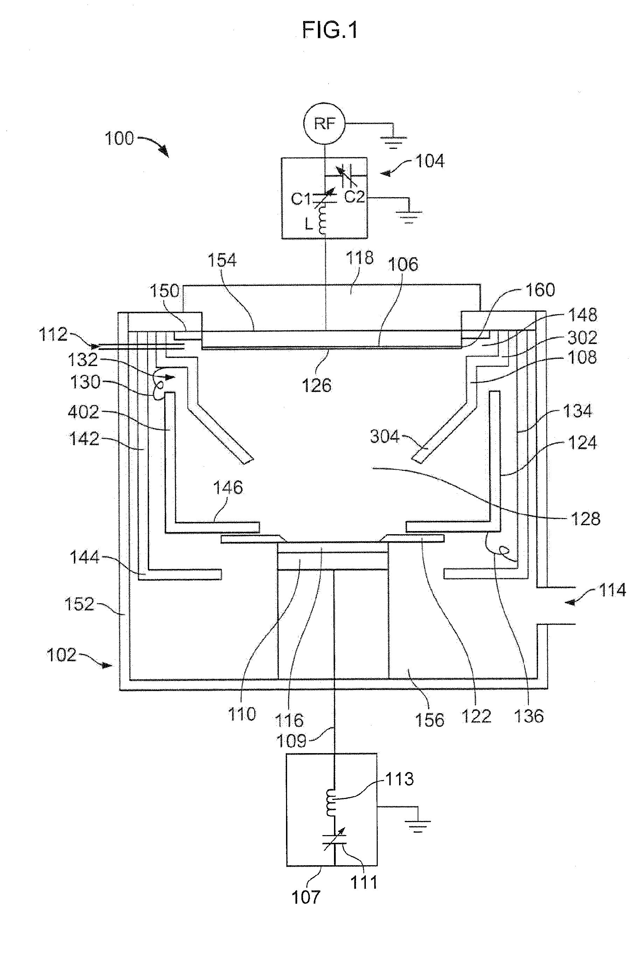

Referring to FIG. 1, a physical vapor deposition apparatus 100 can include a vacuum chamber 102. The vacuum chamber 102 can be cylindrical and have side walls 152, a top surface 154, and bottom surface 156. A magnetron assembly 118 can be located at the top of vacuum chamber 102. The magnetron assembly 118 can include a set of magnets having alternating magnetic poles. The magnetron assembly 118 can be stationary or can rotate about an axis perpendicular to a radius of vacuum chamber 102. The physical vapor deposition apparatus 100 can further include an RF power supply 104 and a corresponding load matching network, which can match the impedance of the power supply 104 to that of vacuum chamber 102.

A cathode assembly 106 can be housed inside and near the top surface 154 of vacuum chamber 102. Cathode assembly 106 can include a target 126 that can be bonded to a metallic backing plate (not shown). The target 126 can be generally circular, with an outer edge 160. The target can be made of, for example, a dielectric material such as lead zirconate titanate ("PZT"). Cathode 106 can act as an electrode for RF current when RF power is applied by RF power supply 104. Cathode assembly 106 can be electrically isolated from the vacuum chamber 102 by an insulator ring 150.

A substrate support or chuck 110 to support one or more substrates can be housed inside vacuum chamber 102 near, but spaced above, the bottom surface 156 of the vacuum chamber 102. The chuck 110 can include a substrate holding mechanism 122, such as a substrate clamping plate, configured to hold substrate 116 such that substrate 116 can be coated with a thin film during the PVD process. Substrate 116 can be, for example, a microelectromechanical system (MEMS) wafer. A temperature control (not shown) can be located on the chuck 110 to, for example, maintain the temperature of substrate 116 at a prescribed temperature between 25°C and 800°C, such as 650°C to 700°C.

In one embodiment, shown in FIG. 1, the chuck 110 can be electrically connected to ground through an impedance matching network 107. The chuck 110 itself can be considered isolated or floating relative to ground, depending on the properties of the impedance matching network. For example, the chuck 110 can be isolated from ground for DC current, but still electrically connected to ground in terms of RF current, with RF impedance depending of the inductance and capacitance of the circuit elements. No secondary RF power supply is connected to chuck 110. An input terminal 109 can electrically connect the impedance matching network 107 to the chuck 110.

The impedance matching network 107 can include a variable tune capacitor 111 and an inductor 113. The variable tune capacitor 111 and an inductor 113 can be connected in series. The variable tune capacitor 111 can be electrically connected to ground. The inductor 113 can be electrically connected between the input terminal 109 and the variable tune capacitor 111. The inductor can have an inductance of about 300µH to 600µH.

The impedance matching network 107 can be tuned to a frequency of about 5 to 100 MHz.

In some implementations, the impedance matching network 107 consists of only the variable tune capacitor 111 and the inductor 113. Having additional electrical elements can introduce additional sources of variation in the electrical performance of the apparatus 100, and therefore a simplified LC circuit with only the variable tune capacitor 111 and the inductor 113 can be more stable and easier to tune to provide the desired bias. In addition, the simplified LC circuit has a single path for current from the input terminal 109 to ground, so it should not experience circular currents.

An anode 108 can also be housed inside vacuum chamber 102. The anode 108 can provide a counterpart electrode to the cathode 106 so as to provide an RF current return path.

In some embodiments, the anode 108 and the chuck 110 can be the same component. In other embodiments, however, as described herein, the anode 108 may be electrically isolated from the chuck 110 so that the chuck 110 can be floating or held at a different potential than the anode 108. The anode can be grounded, i.e., electrically connected in this context (the anode need not be actually connected to ground), to the vacuum chamber sidewalls 152.

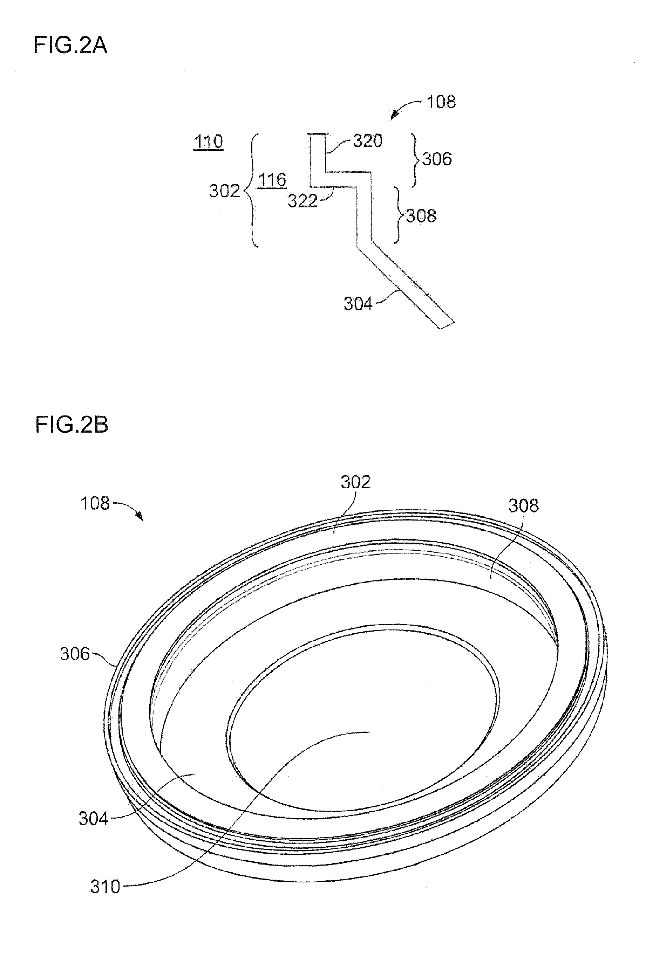

Referring to FIGS. 1 and 2A-2B, the anode 108 can have an annular body 302 and can be extended by an annular flange 304 projecting inwardly from the annular body 302.

The annular flange 304 can define an intended discharge space 128 (see FIG. 1) in which plasma can be retained during the PVD process. As shown in FIGS. 2A and 2B, the annular body 302 can comprise an upper portion 306 and a lower portion 308. The upper portion 306 can be closer to the cathode 106 than the lower portion 308. The spacing 148 (see FIG. 1) between the upper portion 306 and the top surface 154 of vacuum chamber 102 can be configured to prevent plasma formation therebetween.

Shown in FIG. 2A, a top portion 320 of the upper portion 306 of the anode can extend vertically, e.g., it can be a cylinder, from the top surface 154 of the vacuum chamber. The top portion 320 can be parallel to and surround edge 160 of target 126. A bottom portion 322 of the upper portion 306 can extend, e.g., perpendicularly, inwardly from an inside surface at the bottom edge of top portion 320. Bottom portion 322 can extend substantially horizontally inwardly, e.g., as a horizontal ring. The inner radius of the ring 322 can have approximately the same radius as the outer edge 160 of the target 126. Lower portion 308 can extend from a lower surface and an inner edge of bottom portion 322. Lower portion 308 can extend perpendicularly from bottom portion 322 and can extend vertically, e.g., as a cylinder. An inside wall of the cylinder can have approximately the same radius as the outer edge 160 of the target 126. Although not shown, another projection can extend downwardly from the lower surface of bottom portion 322 near the outside edge such that a gap is formed for the placement of an upper portion of shield 124.

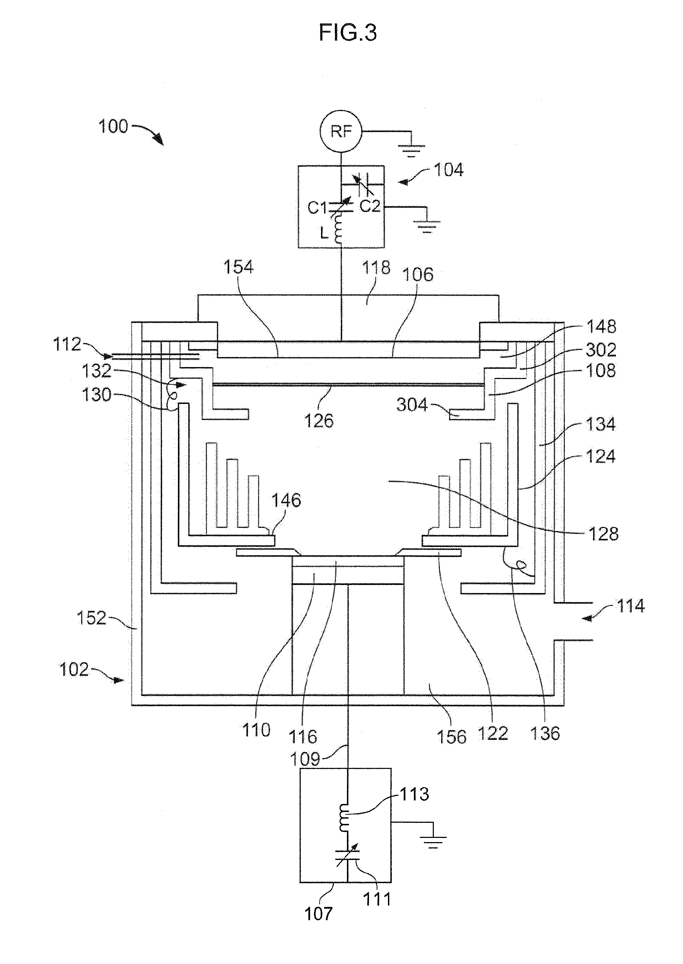

The annular flange 304 can project inwardly from the lower portion 308 such that at least some of the flange extends below target 126. As shown in FIG. 1, the flange 304 can extend inwardly and downwardly from the annular body 302 such that the radius of the flange 304 closer to the cathode 106 is larger than the radius of the flange 304 further from the cathode 106, i.e., the flange can have a funnel shape. Alternatively, as shown in FIG. 3, the flange 304 can extend horizontally from the annular body 302. In some embodiments, the flange 304 extends from the lowermost edge of the lower portion 308.

An annular opening 310 (see FIG. 2B) can have approximately the same radius as the chuck 110 such that there is no substantial shadowing of the substrate 116 during the PVD process, i.e. such that the entire top surface of substrate 116 can be covered with a thin film.

The vacuum chamber 102 can also include an RF shield 124 to protect the sidewalls of vacuum chamber 102 from being coated with thin film material. The shield 124 can be made, for example, of non-magnetic stainless steel or aluminum and can be grounded to the sidewalls 152 of the vacuum chamber 102.

In some implementation shown in FIG. 1, the shield 124 can include an annular body 402 that extends vertically, e.g., in a cylindrical shape. A horizontally extending flange 146 can extend inwardly from a bottom edge of the annular body 402. The horizontally extending flange 146 can be located near the bottom of the vacuum chamber 102 and can extend past the flange 304 to surround and partially vertically overlap the lower portion 308 of the anode 108. In some embodiments, the vertically extending flange 146 can extend into a gap between the lower portion 308 of the anode 108 and substrate holding mechanism 122.

The flange 146 can partially horizontally overlap the substrate holding mechanism 122.

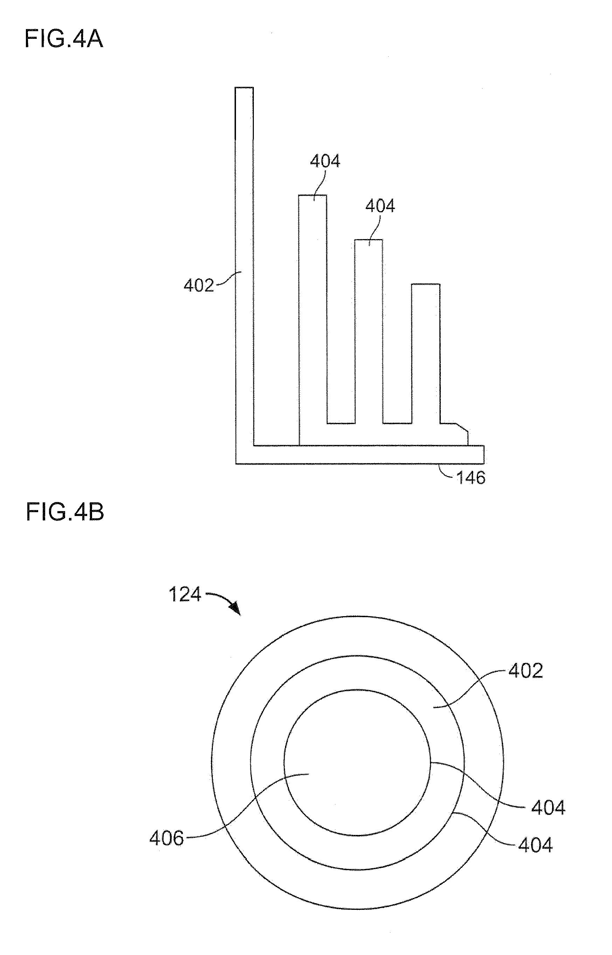

The annular opening 406, in FIG. 4B, inside the annular flange 146 of the shield 124 can have approximately the same radius as the chuck such that there is no substantial shadowing of the substrate 116. A gap 132 can exist between the shield 124 and the anode 108 in order to permit process gas to be evacuated from the intended discharge space 128.

In some embodiments, shown in FIG. 3 and 4A-4B the shield can be extended such that a set of concentric annular projections 404 projects from the annular flange 146, for example towards the cathode 106. The annular projections 404 can extend parallel to annular body 402. As shown in FIGS. 3 and 4A-4B, the height of the annular projections 404 can increase along a radius from the center of the vacuum chamber 102 to the sidewalls 152. The annular body 402 can have a height that is taller than the height of the annular projections 404.

The physical vapor deposition apparatus 100 can further include an electrically conductive body 130, for example a strap, that directly connects the anode 108 and the shield 124. The electrically conductive body 130 can be flexible and can be configured to permit gas flow between the anode 108 and shield 124. For example, the electrically conductive body 130 can be a mesh or a wire strap. The electrically conductive body 130 can be made, for example, of copper or aluminum.

There can be a number of connections between the anode 108 and shield 124. For example, the electrically conductive body 130 can be connected to the anode 108 and the shield 124 at at least four points. The electrically conductive body 130 can be connected between a lower surface of the anode 108 and a top portion of the shield 124. The electrically conductive body 130 can also be connected between a top portion of the anode 108 and an outer surface of the shield 124.

The physical vapor deposition apparatus 100 can further include a secondary chamber shield 134. The chamber shield can be made of, for example, non-magnetic stainless steel or aluminum. An upper portion of the chamber shield can be positioned between the anode 108 and the sidewalls of the vacuum chamber 102. A lower portion of the chamber shield 134 can be positioned between the sidewalls of the vacuum chamber 102 and shield 124. The chamber shield 134 can be concentric with and surround shield 124 and/or anode 108. The height of the chamber shield 134 can be equal to or greater than the height of shield 124. The chamber shield 134 can include a vertical annular body 142 and an annular flange 144 (shown in FIG. 1) extending inwardly from the annular body 142, e.g., from the lower edge of the vertical annular body 142. The annular flange 144 of the chamber shield 134 can extend below the annular flange 146 of shield 124, but can have a radial length that is shorter than the annular flange 146. The annular flange 144 can be closer to the bottom of the chamber than the chuck 110. The inner edge of the flange 144 of the chamber shield can be vertically aligned with the outer edge of the chuck 110.

The physical vapor deposition apparatus 100 can further include a process gas inlet 112, process gas control devices (not shown), a vacuum outlet 114, pressure measurement and control devices (not shown), and vacuum pumps (not shown). The chamber shield 134 can be configured such that process gases may still be pumped into and out of the vacuum chamber 102. For example, the chamber shield 134 may be short enough so as not to cover a process gas inlet 112 or the vacuum outlet 114. Alternatively, the chamber shield 134 may have holes (not shown) in locations corresponding to the locations of the process gas inlet 112 and vacuum outlet 114. Furthermore, the chamber shield 134 can be separately removable and can be cleaned easily and reused over time.

The chamber shield 134 can be electrically bonded to shield 124 with an electrically conductive body 136. The electrically conductive body 136 can be of similar material and shape as electrically conductive body 130. Thus, the electrically conductive body 136 can be configured to permit gas flow between shield 124 and chamber shield 134. Likewise, the electrically conductive body 136 can be composed of mesh, can be one or more straps, and can comprise copper or aluminum. Moreover, the electrically conductive body 136 can be connected between a bottom surface of shield 124 and an inner surface of chamber shield 134.

During the sputtering or PVD process, gases, such as argon and oxygen, are supplied through the process gas inlet 112 at a flow rate of 10-200 sccm/0.2 to 4sccm, such as 10 to 60 sccm/0.5 to 2 sccm. A vacuum pump (not shown) maintains a base vacuum, for example, of 10⁻⁷ Torr or below, and a plasma operation pressure, for example, of 0.5mTorr to 20mTorr, particularly 4mTorr, through vacuum outlet 114. When the RF power from RF power supply 104 is applied on the order of 500W to 5000W, for example 2000W to 4000W, or 3000W, to the cathode assembly 106, the target 126 is negatively biased and the anode 108 is positively biased, causing plasma to form in the intended discharge space 128 between the cathode 106 and the anode 108. The magnetron assembly 118 creates a magnetic field of, for example, 50 Gauss to 400 Gauss, such as 200 Gauss to 300 Gauss, at and near the front surface of the cathode 106. The magnetic field confines the electrons to a helical motion parallel to the front surface of target 126.

The negative self-bias DC voltage on target 126, in conjunction with the electrons confined near the surface of target 126 by the magnetic field, facilitates bombardment of the target 126 by energetic positive ions of the plasma. Momentum transfer causes neutral target material, such as PZT molecules, to dislocate from the target 126 and deposit on substrate 116, creating a thin film on substrate 116. The resulting thin film can have a thickness of 2000Å to 10µm, for example 2-4µm.

In the embodiment shown in FIGS. 1 and 3, when RF power supply 104 is applied to cathode 106, and an impedance matching network 107 is connected to the chuck 110, a DC self-bias can develop on the substrate. The capacitances of the variable tune capacitor 111 can be selected or adjusted, for example to between 10pF and 1200pF, such that the desired DC self-bias is developed on the substrate. As in the embodiment described above, the substrate can have a resulting negative, positive, or zero charge, for example -300V to +300V, in particular -100V to +100V.

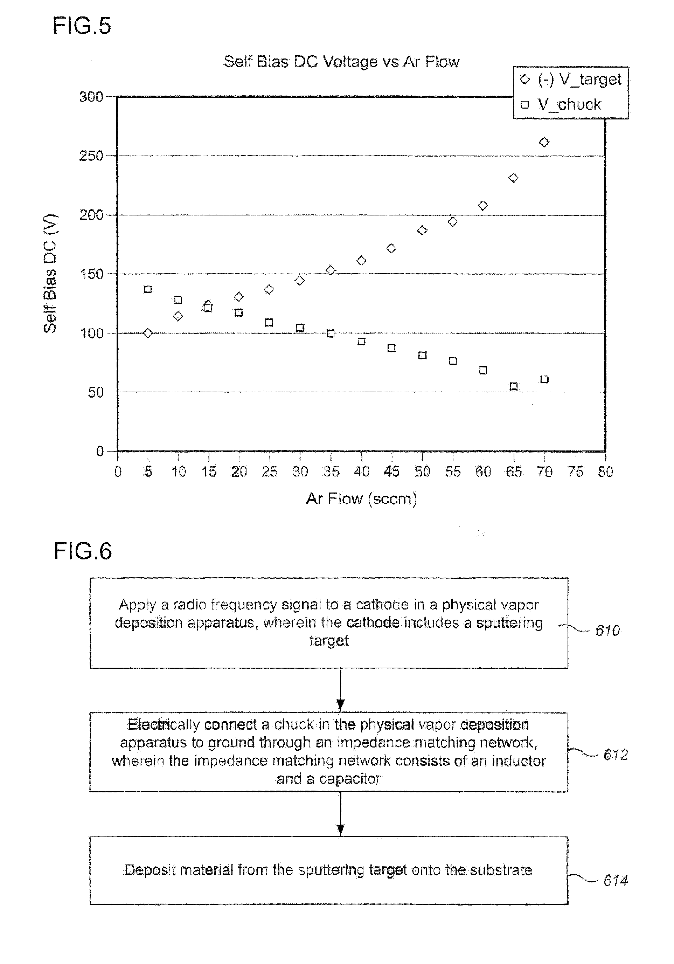

As an example, a graph of a positive self-bias of a substrate vs. gas flow is shown in FIG. 5.

The charge of the DC self-bias can be controlled by the amount of RF power applied to the substrate 116 in addition to the impedance of the impedance matching network 107. In general, to get a positive DC self-bias with the impedance matching network, the resonant frequency should be set slightly smaller than the critical resonant frequency. For example, the resonant frequency can be set 1-2 MHz smaller than the critical resonant frequency. The frequency of the RF power to the cathode can be the same as the critical resonant frequency, e.g., 13.56MHz. With the resonant frequency of the impedance matching network set slightly smaller than critical resonant frequency, a positive DC self-bias, e.g., of 10V-100V, such as 60V, can develop on the substrate 116. On the other hand, the impedance matching network 107 should not be set to have a resonant frequency that is the same as or too close to that of the target RF frequency, because this may resulting in an unstable condition where the bias DC voltage oscillates between positive and negative.

A positive voltage results in attracting and accelerating electrons from the plasma to the surface of substrate 116. Those electrons with sufficient energies will cause modification of the sputtered material properties without causing any substantial re-sputtering due to their low momentum. Moreover, a positive voltage can prevent plasma ions from bombarding the surface of substrate 116 and thus avoid etching of the surface. A negative voltage can cause plasma ions to be attracted and accelerated towards the substrate, which can result in re-sputtering of the surface. Re-sputtering can be useful, for example, for etching the substrate surface. For a given implementation, such as chamber configuration, gas composition and flow rate, pressure, magnetic field, and voltage, experimentation may be required to obtain the RF power and impedance values of the elements in the impedance matching network 107 necessary to generate a positive or negative self-bias voltage.

A flow chart for a process of forming a thin film using the apparatus of FIGS. 1 and 3 is shown in FIG. 6. A radio frequency signal is applied to a cathode in a physical vapor deposition apparatus (step 610). The cathode includes a sputtering target. A chuck supporting a substrate in the physical vapor deposition apparatus is electrically connected to an impedance matching network (step 612). The impedance matching network consists of an inductor and a capacitor. Material from the sputtering target is deposited onto the substrate (step 614). Although not shown in FIG. 6, the process can further include selecting or adjusting a capacitance of the capacitors such that a positive self-bias DC voltage is generated on the substrate.

Use of either an impedance matching network in a physical vapor deposition apparatus can be particularly advantageous for the creation of piezoelectric thin films, such as PZT thin films. In particular, use of an impedance matching network 107 to create an indirect bias on the substrate or deposited film is advantageous because an external DC bias cannot be directly applied to a dielectric material such as PZT. Furthermore, the impedance matching network 107 can modify the electric field strength in the dark space between substrate 116 and the intended discharge space 128, thereby changing the re-sputtering effects of the deposition process. In contrast, while directly biasing a substrate can shift the overall system voltages into an offset value to both the target and/or the substrate, it cannot modify the dark space between substrate 116 and the intended discharge space 128.

If PZT films are sputtered using a physical vapor deposition apparatus having a substrate with a positive DC self-bias as described herein, the electrons that are attracted to the surface of the substrate can cause electron heating, which can increase the mobility of the thin films atoms. Further, the electrons on the surface can help reject plasma ions from the surface to avoid re-sputtering of the surface. As a result, a film having a preferable structure, for example, a thin film having a (100) crystalline structure, can be formed. Such films sputtered on a substrate having a positive DC self-bias, for example a PZT film having a Perovskite PZT (100)/(200) crystal orientation, can have advantageous dielectric and piezoelectric properties, such as a dielectric constant in the range of 1000 to 1700, a high d31 coefficient (e.g., about 250 pm/V or greater), and a high break-down strength (e.g., 1MV/cm or greater). For example, PZT thin films having a (100) crystal orientation can be used as MEMS devices, such as actuators for ink dispensing devices.

A number of embodiments have been described. Nevertheless, it will be understood that various modifications may be made without departing from the scope of what is described. For example, it should be understood that terms of positioning and orientation (e.g., top, vertical) have been used to describe the relative positioning and orientation of components within the physical vapor deposition apparatus, but the physical vapor deposition apparatus itself can be held in a vertical or horizontal orientation or some other orientation.

As another example, the steps of the exemplary flow chart of FIG. 6 may be performed in other orders, some steps may be removed, and other steps may be added. Accordingly, other embodiments are within the scope of the following claims.

## Claims

1. A method of physical vapor deposition comprising:
applying a radio frequency signal to a cathode in a physical vapor deposition apparatus, wherein the cathode includes a sputtering target, wherein the target comprises lead zirconate titanate ("PZT");
electrically connecting a chuck in the physical vapor deposition apparatus to ground through an impedance matching network, wherein the chuck supports a substrate, and wherein the impedance matching network consists only of an inductor in series with a capacitor; wherein an inductance of the inductor has a magnitude of between 300µH and 600µH and wherein the impedance matching network is tuned to a frequency of about 5 to 100 MHz and is about 1 to 2 MHz higher or lower than a frequency of the radio frequency signal applied to the cathode; and
depositing material from the sputtering target onto the substrate.

2. The method of claim 1, further comprising selecting or adjusting a capacitance of the capacitor such that a positive self-bias direct current voltage is generated on the substrate.

3. The method of claim 2, wherein the positive self-bias direct current voltage is between 10 and 100V, preferably between 60 and 75V.

4. The method of claim 2 or 3, wherein the selecting or adjusting the capacitance of the capacitor comprises selecting or adjusting the capacitance to have a magnitude of between 10pF and 1200pF.

5. The method of any of claims 1 to 4, wherein the radio frequency signal has a radio frequency power having a magnitude of between 1000W and 5000W.

6. The method of any of claims 1 to 5, wherein depositing material from the sputtering target onto the substrate comprises creating a thin film having a thickness of between 2000 Å and 10µm, preferably between 2µm and 4µm, and optionally having a (100) crystalline structure.

## Patentansprüche

1. Verfahren von physikalischer Gasphasenabscheidung, umfassend:
Anlegen eines Radiofrequenzsignals an eine Kathode in einem Gerät zur physikalischen Gasphasenabscheidung, wobei die Kathode ein Sputtertarget umfasst, wobei das Ziel Bleizirkonattitanat ("PZT") umfasst;
elektrisches Verbinden eines Spannfutters im Gerät zur physikalischen Gasphasenabscheidung mit Masse durch ein Impedanzabgleichnetzwerk, wobei das Spannfutter ein Substrat trägt und wobei das Impedanzabgleichnetzwerk nur aus einer Drosselspule in Serie mit einem Kondensator besteht;
wobei eine Induktivität der Drosselspule eine Größenordnung von zwischen 300µH und 600µH aufweist und wobei das Impedanzabgleichnetzwerk auf eine Frequenz von ungefähr 5 bis 100 MHz abgestimmt ist und ungefähr 1 bis 2 MHz höher oder niedriger ist als eine Frequenz des Radiofrequenzsignals, welches an der Kathode angelegt ist; und
Abscheiden von Material vom Sputtertarget auf das Substrat.

2. Verfahren nach Anspruch 1, des Weiteren umfassend Auswählen oder Anpassen einer Kapazität des Kondensators, so dass eine Gleichstromspannung mit positiver Eigenvorspannung auf dem Substrat erzeugt wird.

3. Verfahren nach Anspruch 2, wobei die Gleichstromspannung mit positiver Eigenvorspannung zwischen 10 und 100V, vorzugsweise zwischen 60 und 75V beträgt.

4. Verfahren nach Anspruch 2 oder 3, wobei das Auswählen oder Anpassen der Kapazität des Kondensators das Auswählen oder Anpassen der Kapazität umfasst, um eine Größenordnung von zwischen 10pF und 1200pF aufzuweisen.

5. Verfahren nach einem beliebigen der Ansprüche 1 bis 4, wobei das Radiofrequenzsignal eine Radiofrequenzleistung mit einer Größenordnung von zwischen 1000W und 5000W aufweist.

6. Verfahren nach einem beliebigen der Ansprüche 1 bis 5, wobei Abscheiden von Material vom Sputtertarget auf das Substrat das Erzeugen eines Dünnfilms mit einer Dicke von zwischen 2000Ä und 10µm, vorzugsweise zwischen 2µm und 4µm und wahlweise mit einer (100) Kristallstruktur umfasst.

## Revendications

1. Procédé de dépôt physique en phase vapeur comprenant les étapes ci-dessous consistant à :
appliquer un signal de fréquence radio à une cathode dans un appareil de dépôt physique en phase vapeur, dans lequel la cathode inclut une cible de pulvérisation, dans lequel la cible comprend du titano-zirconate de plomb (« PZT ») ;
connecter électriquement un support de tranche, dans l'appareil de dépôt physique en phase vapeur, à la terre, à travers un réseau d'adaptation d'impédance, dans lequel le support de tranche prend en charge un substrat, et dans lequel le réseau d'adaptation d'impédance se compose uniquement d'une bobine d'induction en série avec un condensateur ;
dans lequel une inductance de la bobine d'induction présente une grandeur comprise entre 300 µH et 600 µH, et dans lequel le réseau d'adaptation d'impédance est syntonisé sur une fréquence de l'ordre de 5 à 100 MHz, et est supérieur ou inférieur de 1 à 2 MHz à une fréquence du signal de fréquence radio appliqué à la cathode ; et
déposer un matériau à partir de la cible de pulvérisation sur le substrat.

2. Procédé selon la revendication 1, comprenant en outre l'étape consistant à sélectionner ou à ajuster une capacité du condensateur de sorte qu'une tension à courant continu à auto-polarisation positive est générée sur le substrat.

3. Procédé selon la revendication 2, dans lequel la tension à courant continu à auto-polarisation positive est comprise entre 10 et 100 V, de préférence entre 60 et 75 V.

4. Procédé selon la revendication 2 ou 3, dans lequel la sélection ou l'ajustement de la capacité du condensateur consiste à sélectionner ou à ajuster la capacité de manière à ce qu'elle présente une grandeur comprise entre 10 pF et 1 200 pF.

5. Procédé selon l'une quelconque des revendications 1 à 4, dans lequel le signal de fréquence radio présente une puissance de fréquence radio ayant une grandeur comprise entre 1 000 W et 5 000 W.

6. Procédé selon l'une quelconque des revendications 1 à 5, dans lequel le dépôt de matériau à partir de la cible de pulvérisation sur le substrat comprend la création d'une couche mince présentant une épaisseur comprise entre 2 000 Ǻ et 10 µm, de préférence entre 2 µm et 4 µm, et présentant facultativement une structure cristalline (100).
